# EUROPEAN PATENT SPECIFICATION

(11) **EP 2 346 083 B1**
(45) Date of publication and mention of the grant of the patent: **30.03.2016**
(21) Application number: 09814664.0
(22) Date of filing: 18.09.2009
(51) Int. Cl.: H01L 29/84, G01P 15/08, G01P 15/125, G01P 1/02, B81B 7/00

(54) **MEMS SENSOR**
MEMS-SENSOR
CAPTEUR MEMS

(30) Priority: 22.09.2008 JP 2008242362
(43) Date of publication of application: 20.07.2011
(73) Proprietor: Alps Electric Co., Ltd., Tokyo 145-8501 (JP)
(72) Inventor: TAKAHASHI, Toru, Tokyo 145-8501 (JP); GOCHO, Hideki, Tokyo 145-8501 (JP); KOBAYASHI, Kiyoshi, Tokyo 145-8501 (JP)
(74) Representative: Klunker . Schmitt-Nilson . Hirsch
(86) International application number: PCT/JP2009/066354
(87) International publication number: WO 2010/032820

(56) References cited:
- EP-A1- 1 296 374
- WO-A1-2007/078472
- JP-A- 2002 076 269
- JP-A- 2003 329 704
- JP-A- 2005 236 159
- JP-A- 2007 000 986
- US-A1- 2002 019 079

## Description

### TECHNICAL FIELD

The present invention relates to an MEMS sensor including a movable electrode unit and a fixed electrode unit supported via an insulating layer between a first substrate and a second substrate which are vertically arranged with an interval.

### BACKGROUND ART

An MEMS (Micro-Electro-Mechanical Systems) sensor includes a movable electrode unit and a fixed electrode unit which are formed by micromachining a silicon (Si) substrate constituting a SOI (Silicon on Insulator) substrate. This micro sensor is used as an accelerator sensor, a pressure sensor, a vibratory gyroscope, a micro relay and the like by operation of the movable electrode unit.

This type of MEMS sensor is required to seal a movable region of the movable electrode unit so that the movable electrode unit formed in a portion of the silicon substrate can be operated over a minute distance within a clean space.

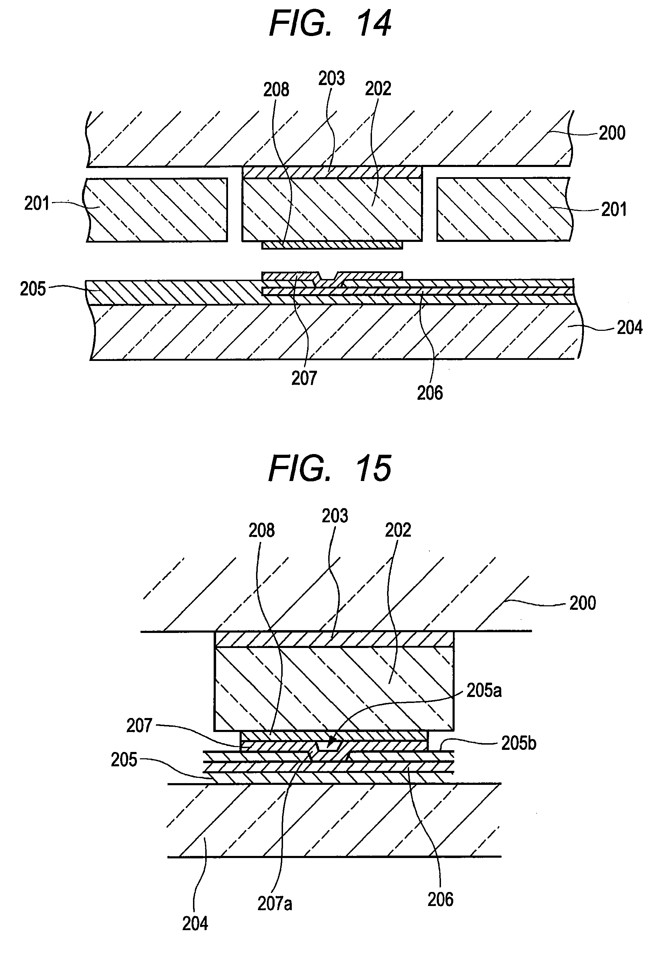

Fig. 14 is a sectional view of a portion of an MEMS sensor as a comparative example which serves as the premise leading to the present invention.

As shown in Fig. 14, an MEMS sensor includes a first substrate 200, a movable region 201 constituted by a movable electrode unit and a fixed electrode unit, support conductive units 202 of the respective movable electrode and fixed electrode units, and a first insulating layer 203 interposed between each support conductive unit 202 and the first substrate 200. In addition, a second substrate 204 is disposed with a vertical interval to the first substrate 200 and a second insulating layer 205 is formed on a surface of the second substrate 204.

As shown in Fig. 14, a lead layer 206 is embedded in the second insulating layer 205. As shown in an enlarged view of Fig. 15, a concave portion 205a is formed in the second insulating layer 205 and a surface of the lead layer 206 is exposed from the concave portion 205a. In addition, a connection electrode unit 207 connected to each support conductive unit 202 is formed across a surface 205b of the second insulating layer 205 from the concave portion 205a.

In addition, a connection metal layer 208 formed on a surface of each support conductive unit 202 is bonded to the connection electrode unit 207.

EP 1 296 274 A1 discloses a process of bonding two distinct substrates that integrate a microsystem in at least one of the two substrates using, wherein the bonding is performed by making on a first substrate bonding regions of deformable material and by pressing said substrates one against another so as to deform the bonding regions and to cause them to react chemically with the second substrate, whereby spacing regions guarantee exact spacing between the two wafers.

JP 2005-236159 A discloses a wafer level hermetically-sealed package, which comprises a main substrate, an opposing substrate arranged to be nearly parallel in its main surface to the main substrate, and joints for fixing the opposing substrate and the main substrate so that a space surrounded by the main substrate, the opposing substrate and the joints is made to be evacuated, wherein the joints include a low-melting-point first solder and a high-melting-point solder higher in melting point than the first solder.

WO 2007/078472 A1 discloses an encapsulated device with a hermetic seal which seals an insulating environment between two substrates, one of which supports the device, wherein the hermetic seal is formed by an alloy of two metal layers, one deposited on the first substrate and the other deposited on the second substrate, along with a raised feature formed on the first or the second substrate. At least one of the metal layers may be deposited conformally over the raised feature so that the raised feature penetrates the molten material of the first or the second metal layers during formation of the alloy.

US 2002/0019079 A1 discloses a small size electronic part comprising a silicon substrate having a functional element and a signal output portion to output a signal from the functional element to outside the electronic part; a glass substrate provided on the silicon substrate such that the signal output portion of the silicon substrate is in contact with the glass substrate; a communicating hole provided in the glass substrate and at least a portion of the signal output portion of the silicon substrate so as to pass through the glass substrate and cut into at least a part of the signal output portion; and a conductive film provided on an inner wall surface of the communicating hole and extending on a surface of the glass substrate.

JP 2007-000986 A discloses a hermetically sealed micro structure equipped with: a first substrate having a recessed part; and a second substrate which is composed of a multi-layer substrate, connected to the first substrate to seal the recessed part and to form a sealing space between the substrate and the second substrate. First and second conductive patterns and a via hole exposing a third conductive pattern provided inside of the second substrate are provided respectively. The first and second conductive patterns are mutually coupled through a forth conductive pattern and the third conductive pattern provided in the via hole.

JP 2003-329704 A discloses an inertial sensor with a sealed structure, wherein the inertial sensor comprises a movable structure movable in response to an inertial force, and an outer wall for forming an internal space for disposing a fixed electrode for measuring the displacement of the structure. A silicon cap wafer is disposed above the space, and connected to the upper part of the wall to seal the space. An I/O electrode for outputting a signal due to the electrode or inputting a signal for controlling the electrode from an external unit is formed on the wafer.

### DISCLOSURE OF THE INVENTION

### PROBLEMS TO BE SOLVED BY THE INVENTION

The MEMS sensor shown in Fig. 14 has the merit that it can be thinned and slimmed as it is configured such that the movable region 201 constituted by the movable electrode unit and the fixed electrode unit is interposed with a narrow interval between the first substrate 200 and the second substrate 204 and each support conductive unit 202 is fixed and supported via the thin insulating layers 203 and 205.

However, the MEMS sensor shown in Figs. 14 and 15 has been found to have the following problems.

That is, as shown in Fig. 15, a concave region 207a emulating the concave portion 205a formed in the second insulating layer 205 is formed in the connection electrode unit 207. Since the concave region 207a becomes a portion which is not bonded to the connection metal layer 208, a bonding area is reduced to deteriorate a bonding strength. In addition, sizes of planes of the concave region 207a are likely to be different from each other and a variation of a bonding strength may occur due to a variation of bonding area.

In this kind of MEMS sensor, since the movable region 201 for detecting physical quantities takes a wide plane, a planar shape of the support conductive unit 202 is necessarily formed to be small. Accordingly, the bonding area between the connection metal layer 208 and the connection electrode unit 207 is small from the outset. Accordingly, the non-bonding portion is a non-negligible region in securing the bonding area as widely as possible.

It is an object of the present invention to provide an MEMS sensor with an improved bonding structure where each of support conductive units of a movable electrode and a fixed electrode unit, which are supported to a first substrate, is bonded to a lead layer embedded in an insulating layer at a second substrate side facing the first substrate with an interval therebetween.

### MEANS FOR SOLVING THE PROBLEMS

The object is solved by the features of independent claim 1. Further embodiments are defined in the thereon dependent claims. An MEMS sensor according to the present invention includes: a first substrate; a second substrate; and a functional layer including a movable electrode unit and a fixed electrode unit which are interposed between the first substrate and the second substrate, wherein each of support conductive units of the movable electrode unit and the fixed electrode unit is fixedly supported via a first insulating layer formed on a surface of the first substrate, a second insulating layer, a lead layer and a connection electrode unit are formed on a surface of the second substrate, the lead layer being embedded in the second insulating layer, and the connection electrode unit making electrical connection with the lead layer and being individually connected to the support conductive units, a concave portion penetrating up to a surface of the lead layer is formed in a surface of the second insulating layer, the connection electrode unit includes a concave region emulating the concave portion formed in the second insulating layer and a connection region extending on the surface of the second insulating layer from one of both ends of the concave region, and the support conductive units are bonded to the connection region of the connection electrode unit. With this configuration, a bonding area between the support conductive unit and the connection electrode unit can be widened, thereby increasing a bonding strength, and a variation of a bonding area can be small, thereby achieving a stable bonding strength.

In the present invention a connection metal layer is formed on a surface of each of the support conductive units and is eutectic-bonded or diffusion-bonded to the connection region of the connection electrode unit. With this configuration, it is possible to effectively increase a bonding strength between the support conductive unit and the connection electrode unit. In addition, since the thickness of the bonding layer is very small, an interval between the first substrate and the second substrate can be determined with high precision and it is possible to realize a thin MEMS sensor with high dimension precision and high bonding strength.

In the present invention a frame layer is formed at the same thickness as the movable electrode unit and the fixed electrode unit and is made of the same material as the movable electrode unit and the fixed electrode unit, the frame layer surrounding a movable region of the movable electrode unit, the first substrate is bonded to the frame layer in the outer circumference of the movable region via an insulating layer equal to the first insulating layer, and a seal electrode unit made of the same metal material as the connection electrode unit is formed on the surface of the second insulating layer, a seal metal layer made of the same metal material as the connection metal layer is formed on a surface of the frame layer, and the seal electrode unit and the seal metal layer are eutectic-bonded or diffusion-bonded to each other to form a seal layer to surround the outer circumference of the movable region. With this configuration, when the seal metal layer is formed by the eutectic-bonding or diffusion-bonding between the second insulating layer and the frame layer, a seal structure surrounding the movable region of the movable electrode unit can be configured to be thin and a distance between the first substrate and the second substrate can be uniformly maintained. Accordingly, it is possible to realize a thin MEMS sensor with high sealability and dimension precision and high bonding strength.

In the present invention the connection electrode unit includes a first concave region and a second concave region, which are connected to the lead layer at a predetermined interval, and the connection region interposed between the first concave region and the second concave region. With this configuration, a variation of a bonding area can be more effectively reduced, thereby achieving a more stable bonding strength.

In the present invention, preferably, an IC package is used instead of the second substrate, the second insulating layer is formed on a surface of the IC package, and a concave region of the connection electrode unit is directly or indirectly connected to an electrode pad of the IC package.

### ADVANTAGE OF INVENTION

According to the MEMS sensor in the present invention, a bonding area between the support conductive unit and the connection electrode unit can be increased and the bonding strength can be improved. Furthermore, a variation of a bonding area can be reduced, thereby achieving a stable bonding strength.

### BEST MODE FOR CARRYING OUT THE INVENTION

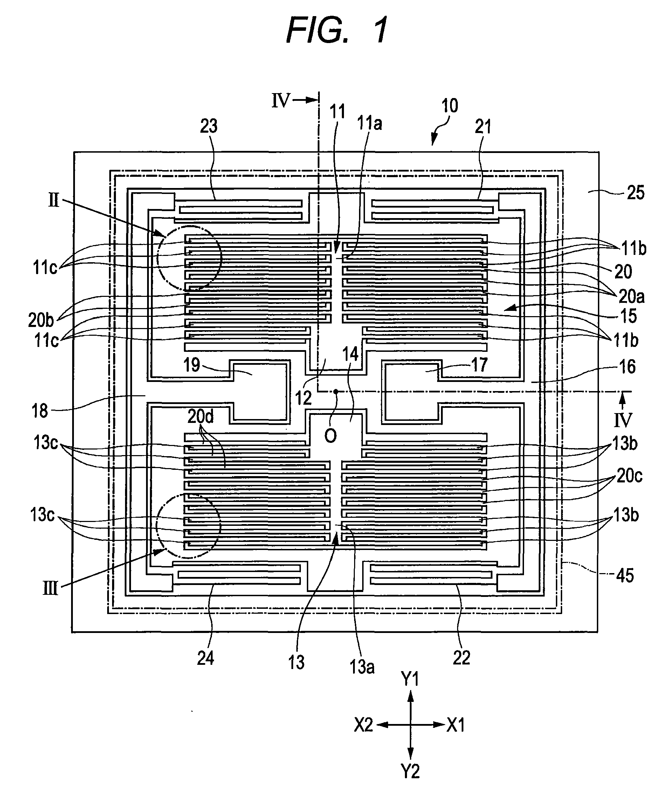

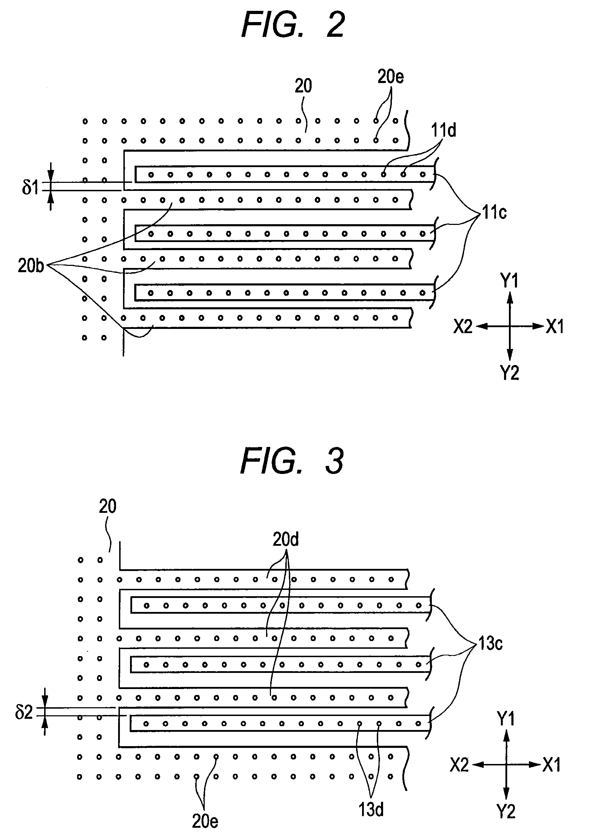

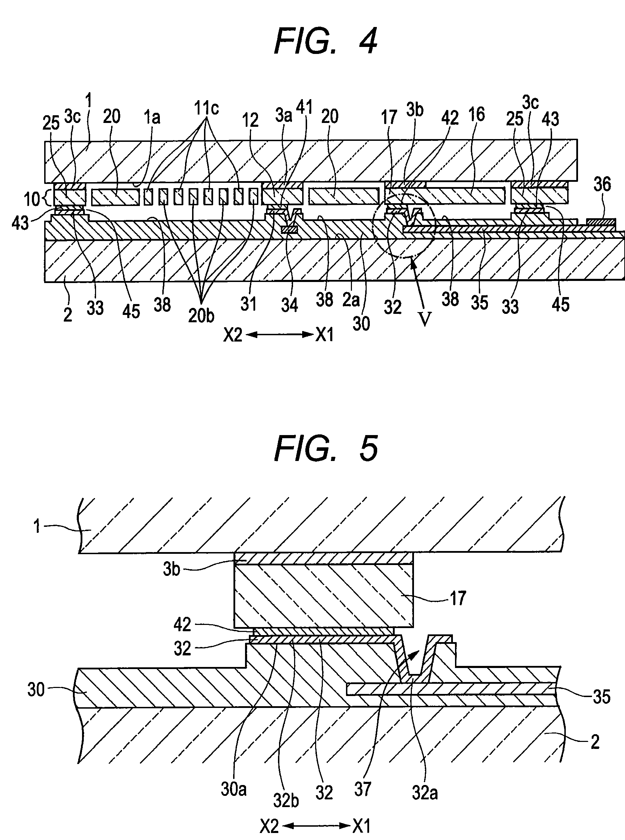

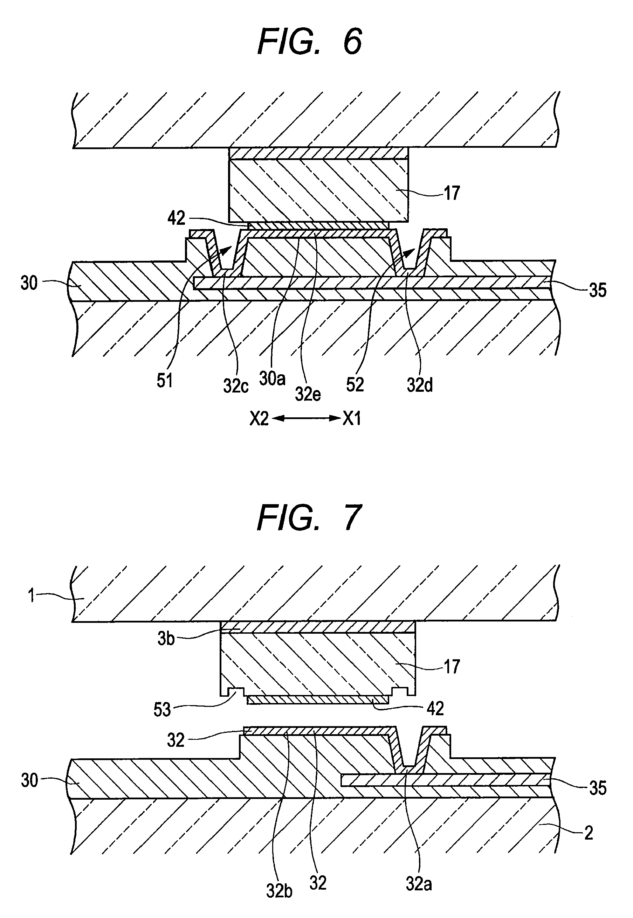

Fig. 1 is a plan view of an MEMS sensor according to an embodiment of the present invention, showing a movable electrode unit, a fixed electrode unit and a frame layer. A first substrate and a second substrate are not shown in Fig. 1. Fig. 2 is an enlarged plan view of a portion indicated by an arrow II in Fig. 1 and Fig. 3 is an enlarged plan view of a portion indicated by an arrow III in Fig. 1. Fig. 4 is a sectional view showing the entire structure of an MEMS sensor, which is not part of the claimed invention, corresponding to a sectional view taken along line IV-IV in Fig. 1. Fig. 5 is an enlarged sectional view of a portion indicated by an arrow V in Fig. 4. Fig. 6 is an enlarged sectional view of an MEMS sensor according to an embodiment of the invention.

As shown in Fig. 4, an MEMS sensor includes a first substrate 1, a second substrate 2 and a functional layer sandwiched therebetween. Various components of the first substrate 1 and the functional layer 10 are bonded to one another via first insulating layers 3a, 3b and 3c. In addition, a second insulating layer 30 is interposed between the second substrate 2 and the functional layer 10.

The first substrate 1, the functional layer 10 and the first insulating layers 3a, 3b and 3c are formed by machining a SOI (Silicon on Insulator) substrate. A SOI substrate used herein is formed by bonding two silicon substrates together with a SiO₂ layer as an insulator interposed therebetween. One silicon substrate of the SOI substrate is used as the first substrate 1 and the other silicon substrate is machined to form the functional layer 10.

The functional layer 10 is formed with a first fixed electrode unit 11, a second fixed electrode unit 13, a movable electrode unit 15 and a frame layer 25, which are separated from one silicon substrate. In addition, some of the insulating layer of the SOI substrate is removed and the first insulating layers 3a, 3b and 3c are formed to be separated from one another.

As shown in Fig. 1, a planar shape of the functional layer 10 is 180° rotation-symmetric with respect to the center (of the figure) O and is also symmetric in a vertical direction (Y direction) with respect to a line extending in an X direction passing the center O.

As shown in Fig. 1, the first fixed electrode unit 11 is formed in a Y1 direction above the center O. A rectangular support conductive unit 12 is integrated with the first fixed electrode unit 11 at a position approaching the center O. As shown in Fig. 4, the support conductive unit 12 is fixed to a surface 1a of the first substrate 1 by the first insulating layer 3a. In the first fixed electrode unit 11, only the support conductive unit 12 is fixed to the surface 1a of the first substrate 1 by the first insulating layer 3a and other portions are formed with a gap corresponding to a thickness of the first insulating layer 3a between them and the surface 1a of the first substrate 1, with an insulating layer between them and the first substrate 1 removed.

As shown in Fig. 1, the first fixed electrode unit 11 includes an electrode support portion 11a having a constant width extending linearly in the Y1 direction from the support conductive unit 12. A plurality of counter electrodes 11b are integrally formed in an X1 direction of the electrode support portion 11a and a plurality of counter electrodes 11c are integrally formed in an X2 direction of the electrode support portion 11a. One counter electrode 11c is shown in Fig. 2. All of the plurality of counter electrodes 11c extend linearly in the X2 direction and have a constant width in the Y direction. In addition, the plurality of counter electrodes 11c are arranged in a pectinated shape with a constant interval in the Y direction. The other counter electrodes 11b extending in the X1 direction and the counter electrodes 11c extending in the X2 direction are in horizontal symmetry with respect to a line extending in the Y direction passing the center O.

The second fixed electrode unit 13 is arranged in a Y2 direction below the center O. The second fixed electrode unit 13 and the first fixed electrode unit 11 are in vertical (Y direction) symmetry with respect to a line extending in the X direction passing the center O. That is, the second fixed electrode unit 13 includes a rectangular support conductive unit 14 disposed at a position approaching the center O and an electrode support portion 13a having a constant width extending linearly in the Y2 direction from the support conductive unit 14. A plurality of counter electrodes 13b extend from electrode support portion 13a and are integrally formed in the X1 direction of the electrode support portion 13a and a plurality of counter electrodes 13c extend from the electrode support portion 13a and are integrally formed in the X2 direction of the electrode support portion 13a.

As shown in Fig. 3, the counter electrodes 13c extend linearly in the X2 direction, have a constant width, and are formed in parallel with a constant interval in the Y direction. Similarly, the counter electrodes 13b extend linearly in the X1 direction, have a constant width, and are formed in parallel with a constant interval in the Y direction.

Also in the second fixed electrode unit 13, only the support conductive unit 14 is fixed to the surface 1a of the first substrate 1 via the first insulating layer 3a. Other portions, i.e., the electrode support portion 13a and the counter electrodes 13b and 13c, are formed with a gap corresponding to the thickness of the first insulating layer between these portions 13a, 13b and 13c and the surface 1a of the first substrate 1, with an insulating layer between these portions 13a, 13b and 13c and the first substrate 1 removed.

In the functional layer 10 shown in Fig. 1, an inner side of the rectangular frame layer 25 corresponds to a movable region where portions except the first fixed electrode unit 11 and the second fixed electrode unit 13 correspond to the movable electrode unit 15. The movable electrode unit 15 is formed to be separated from the first fixed electrode unit 11, the second fixed electrode unit 13 and the frame layer 25 in the same silicon substrate.

As shown in Fig. 1, the movable electrode unit 15 has a first support forearm portion 16 extending in a Y1-Y2 direction toward the X1 side beyond the center O and is provided with a rectangular support conductive unit 17 integrated with the first support forearm portion 16 at a position near the X1 side of the center O. In addition, the movable electrode unit 15 has a second support forearm portion 18 extending in the Y1-Y2 direction toward the X2 side beyond the center O and is provided with a rectangular support conductive unit 19 integrated with the second support forearm portion 18 at a position near the X2 side of the center O.

In a region between the first support forearm portion 16 and the second support forearm portion 18, portions except the first fixed electrode unit 11 and the second fixed electrode unit 13 correspond to a weight portion 20. An edge of the weight portion 20 in the Y1 side is supported to the first support forearm portion 16 via an elastic support portion 21 and is also supported to the second support forearm portion 18 via an elastic support portion 23. In addition, the edge of the weight portion 20 in the Y1 side is supported to the first support forearm portion 16 via an elastic support portion 22 and is also supported to the second support forearm portion 18 via an elastic support portion 24.

In the Y1 side beyond the center O are integrally formed a plurality of movable counter electrodes 20a extending from an edge of the weight portion 20 in the X1 side to the X2 side and a plurality of movable counter electrodes 20b extending from an edge of the weight portion 20 in the X2 side to the X1 side. As shown in Fig. 2, the movable counter electrodes 20b integrated with the weight portion 20 face sides of the counter electrodes 11c of the first fixed electrode unit 11 in the Y2 side with a distance δ1 therebetween upon the stopping of the movable counter electrodes 20b. Similarly, the movable counter electrodes 20a in the X1 side face sides of the counter electrodes 11b of the first fixed electrode unit 11 in the Y2 side with a distance δ1 therebetween upon the stopping of the movable counter electrodes 20a.

In the Y2 side beyond the center O, the weight portion 20 is integrated with a plurality of movable counter electrodes 20c extending in parallel from an edge of the weight portion 20 in the X1 side in the X2 direction and a plurality of movable counter electrodes 20d extending in parallel from an edge of the weight portion 20 in the X2 side to the X1 direction.

As shown in Fig. 3, the movable counter electrodes 20d face sides of the counter electrodes 13c of the second fixed electrode unit 13 in the Y1 side with a distance δ2 therebetween upon the stopping of the movable counter electrodes 20d. This is equally applied between the movable counter electrodes 20c and the counter electrodes 13b in the X1 side. The opposing distances δ1 and δ2 upon the stopping of the movable counter electrodes 20b and 20d are equally designed to have the same dimension.

As shown in Fig. 4, the support conductive unit 17 continuing to the first support forearm portion 16 is fixed to the surface 1a of the first substrate 1 via the first insulating layer 3b and the support conductive unit 19 continuing to the second support forearm portion 18 is also fixed to the surface 1a of the first substrate 1 via the first insulating layer 3b. In the movable electrode unit 15, only the support conductive unit 17 and the support conductive unit 19 are fixed to the first substrate 1 by the first insulating layer 3b and other portions, i.e., the first support forearm portion 16, the second support forearm portion 18, the weight portion 20, the movable counter electrodes 20a, 20b, 20c and 20d and the elastic support portions 21, 22, 23 and 24, are formed with a gap corresponding to a thickness of the first insulating layer 3b between them and the surface 1a of the first substrate 1, with an insulating layer between them and the surface 1a of the first substrate 1 removed.

The elastic support portions 21, 22, 23 and 24 are formed to have a meander pattern in a thin plate spring taken out of the silicon substrate. When the elastic support portions 21, 22, 23 and 24 are deformed, the weight portion 20 is movable in the Y1 or Y2 direction.

As shown in Fig. 1, the frame layer 25 is formed by taking out a silicon wafer forming the functional layer 10 in the form of a rectangular frame. The first insulating layer 3c is left between the frame layer 25 and the surface 1a of the first substrate 1. The first insulating layer 3c is provided to surround the entire outer circumference of the movable region of the movable electrode unit 15.

A method of manufacturing the functional layer 10 as shown in Fig. 4 includes a SOI substrate including two silicon substrates bonded to each other via an insulating layer, forming, on a surface of one of the silicon substrates, a resist layer to cover the first fixed electrode unit 11, the second fixed electrode unit 13, the movable electrode unit 15 and the frame layer 25, and removing some of the silicon substrate at a portion exposed from the resist layer using an ion etching means such as a deep reactive ion etching (RIE) using high density plasma, thereby separating the first fixed electrode unit 11, the second fixed electrode unit 13, the movable electrode unit 15 and the frame layer 25 from one another.

At this point, a plurality of fine holes are formed by means of the deep RIE in all regions except the support conductive units 12, 14, 17 and 19 and the frame layer 25. Figs. 2 and 3 show fine holes 11d formed in the counter electrodes 11c, fine holes 13d formed in the counter electrodes 13c, and fine holes 20e formed in the weight portion 20.

After subjecting the silicon substrate to an etching process by the deep RIE, a selective isotropic etching process is performed to dissolve an insulating layer, i.e., a SiO₂ layer without dissolving the silicon. At this time, an etching solution or an etching gas permeates into grooves separating the various elements of the silicon substrate as well as the above-mentioned fine holes, thereby removing the insulating layer.

As a result, the first insulating layers 3a, 3b and 3c are left in only a portion between the support conductive units 12, 14, 17 and 19 and frame layer 25 and the surface 1a of the first substrate 1, with the insulating layers removed from other portions.

A thickness of the first substrate 1 processed using the SOI substrate is 0.2 to 0.7 mm or so, a thickness of the functional layer 10 is 10 to 30 µm or so, and a thickness of the first insulating layers 3a, 3b and 3c is 1 to 3 µm or so.

The second substrate 2 is formed by a single layer of silicon substrate having a thickness of 0.2 to 0.7 mm. The second insulating layer 30 is formed on a surface 2a of the second substrate 2. The second insulating layer 30 is an inorganic insulating layer such as SiO₂, SiN, Al₂O₃ or the like and is formed by means of a sputtering process or a CVD process. For the inorganic insulating layer, material is selected which has a difference in thermal expansion coefficient between the material and the silicon substrate which is smaller than a difference in thermal expansion coefficient between conductive metal constituting the connection electrode unit and the silicon substrate. Preferably, SiO₂ or SiN having a relatively small difference in thermal expansion coefficient between it and the silicon substrate is used.

As shown in Fig. 4, a connection electrode unit 31 facing the support conductive unit 12 of the first fixed electrode unit 11 is formed on a surface of the second insulating layer 30, and likely, a connection electrode unit 31 (not shown) facing the support conductive unit 14 of the second fixed electrode unit 13 is formed on the surface of the second insulating layer 30. In addition, a connection electrode unit 32 facing one support conductive unit 17 of the movable electrode unit 15 is formed on the surface of the second insulating layer 30, and likely, a connection electrode unit 32 (not shown) facing the other support conductive unit 19 is formed on the surface of the second insulating layer 30.

A seal electrode unit 33 facing a surface of the frame layer 25 is formed on the surface of the second insulating layer 30. The seal electrode unit 33 is made of conductive metal material like the connection electrode units 31 and 32. The seal electrode unit 33 has a rectangular shape facing the frame layer 25 and is configured to surround the entire circumference of the movable region in the outer circumference of the movable electrode unit 15. The connection electrode units 31 and 32 and the seal electrode unit 33 are made of, for example, aluminum (Al).

A lead layer 34 which makes electrical connection with one connection electrode unit 31 and a lead layer 35 which makes electrical connection with the other connection electrode unit 32 are provided within the second insulating layer 30. The lead layers 34 and 35 are made of, for example, aluminum. The plurality of lead layers 34 and 35 make electrical connection with the respective connection electrode units 31 and 32. In addition, the respective lead layers 34 and 35 pass through the inside of the second insulating layer 30 and traverse a portion where the seal electrode unit 33 is formed, without contacting the seal electrode unit 33, extending to the outside of a region surrounded by the seal electrode unit 33. Connection pads 36, which make electrical connection with the respective lead layers 34 and 35, are formed in the outside of the region in the second substrate 2. The connection pads 36 are made of conductive material which has low resistance and is unlikely to be oxidized, for example, aluminum or gold.

In the second insulating layer 30, a surface on which the connection electrode units 31 and 32 are formed and a surface on which the seal electrode unit 33 is formed are coplanar. In addition, a space portion (concave portion) 38 directing to the surface 2a of the second substrate 2 is formed on the second insulating layer 30 in a region where the connection electrode units 31 and 32 and the seal electrode unit 33 are not formed. The space portion 38 is formed in all portions in the second insulating layer 30 except surfaces 30a facing the support conductive units 12, 14, 17 and 19 and the frame layer 25. In addition, the space portion 38 is formed to be deep without exposing the lead layers 34 and 35 on the way of the second insulating layer 30.

As shown in Fig. 4, connection metal layers 41 facing the respective connection electrode units 31 are respectively formed on the surface of the support conductive units 12 and 14 of the functional layer 10, and connection metal layers 42 facing the respective connection electrode units 32 are respectively formed on the surface of the support conductive units 17 and 19 by means of a sputtering process. In addition, a seal metal layer 43 facing the seal electrode unit 33 is formed on the surface of the frame layer 25. The seal metal layer 43 is made of the same metal material as the connection metal layers 41 and 42.

The connection metal layers 41 and 42 and the seal metal layer 43 are made of germanium which is a metal material which is apt to be eutectic-bonded or diffusion-bonded to aluminum which forms the connection electrode units 31 and 32 and the seal electrode unit 33.

As shown in Fig. 4, the first substrate 1 and the second substrate 2 overlap with each other in such a manner that the surface 1a faces the surface 2a, the connection electrode unit 31 faces the connection metal layer 41, the connection electrode unit 32 faces the connection metal layer 42 and the seal electrode unit 33 faces the seal metal layer 43. Then, the first substrate 1 and the second substrate 2 are pressurized with a weak force while being heated. This allows the connection electrode unit 31 and the connection metal layer 41 to be eutectic-bonded or diffusion-bonded to each other and the connection electrode unit 32 and the connection metal layer 42 to be bonded to each other. When the connection electrode units 31 and 32 are respectively bonded to the connection metal layers 41 and 42, the support conductive units 12, 14, 17 and 19 are fixedly sandwiched between the first insulating layers 3a and 3b and the second insulating layer 30, while the connection electrode units 31 and 31 make respective electrical connection with the support conductive units 12 and 14 and the connection electrode units 32 and 32 make respective electrical connection with the support conductive units 17 and 19.

At the same time, the seal electrode unit 33 and the seal metal layer 43 are eutectic-bonded or diffusion-bonded to each other. This bonding allows the frame layer 25 and the second insulating layer 30 to be strongly fixed to each other and a metal seal layer 45 to be formed to surround the entire circumference of the movable region of the movable electrode unit 15.

In the enlarged sectional view of Fig. 5, of the first support forearm portion 16 and the support conductive unit 17, the first support forearm portion 16 is not shown but the support conductive unit 17 is only shown.

As shown in Fig. 5, a concave portion 37 is formed in the surface 30a at a position facing the support conductive unit 17 of the second insulating layer 30. A surface of the lead layer 35 is exposed in the bottom of the concave unit 37. A concave region 32a emulating the concave portion 37 is formed in the connection electrode unit 32. In addition, in the connection electrode unit 32, a connection region 32b extending only in the X2 direction of both ends in the X1-X2 direction of the concave region 32a is formed on the surface 30a of the flat second insulating layer 30. The connection region 32b has a flat plate shape since it is formed in the surface 30a of the flat second insulating layer 30. In addition, although the planar shape of the connection region 32b is not particularly limited, it is appropriate to have a shape conforming to the support conductive unit 17 (analogous shape). Accordingly, in this embodiment, since the planar shape of the support conductive unit 17 is rectangular, it is also appropriate for the connection region 32b to have a rectangular shape.

Now, a method of forming the second insulating layer 30, the lead layers 34 and 35 and the connection electrode units 31 and 32 will be described. First, an inorganic insulating layer is formed at a predetermined thickness on the surface 2a of the second substrate 2 using a sputtering process, the lead layers 34 and 35 are formed on a surface of the inorganic insulating layer using a sputtering process or the like, and then an inorganic insulating layer is formed to cover the lead layers 34 and 35 using a sputtering process. Thereafter, the entire surface is polished to be in the same level and then the space portion 38 is formed by digging out some of the polished entire surface using an ion milling process or the like. Then, the concave portion 37 is formed in the surface 30a of the second insulating layer 30. Next, the connection electrode units 31 and 32 are formed over a range from the concave portion 37 to the surface 30a of the second insulating layer 30 using a sputtering process or the like.

As shown in Fig. 5, the connection metal layer 42 formed on the surface of the support conductive unit 17 faces the connection region 32b of the connection electrode unit 32, avoiding the concave region 32a thereof, and the connection metal layer 42 and the connection region 32b of the connection electrode unit 32, both of which have a flat plate shape, are eutectic-bonded or diffusion-bonded to each other.

The bonding structure shown in Fig. 5 can further increase a contact area between the support conductive unit 17 and the connection electrode unit 32, as compared to the comparative example shown in Fig. 15. This can improve bonding strength. In addition, unlike the comparative example of Fig. 15, since such bonding is made to avoid the concave region 32a which is a non-bonding region, it is possible to make a variation of the bonding area small and obtain a stable bonding strength.

The bonding structure shown in Fig. 5 can be equally applied to other support conductive units 12, 14 and 19.

This MEMS sensor has a structure where the SOI substrate including two silicon substrates bonded to each other via a first insulating layer overlaps with another single silicon substrate via a second thin insulating layer, thereby leading to thinness of the sensor. In addition, as shown in Fig. 5, by forming the connection region 32b extending the connection electrode unit 32 only in one direction from the concave region 32a and bonding the connection region 32b and the support conductive unit 17 together, it is possible to achieve a thin MEMS sensor having a strong bonding strength.

In addition, as the support conductive units 12, 14, 17 and 19 and the second insulating layer 30 are eutectic-bonded or diffusion-bonded to the connection electrode units 31 and 32 and the connection metal layers 41 and 42, the bonding strength can be more effectively increased. In addition, this bonding layer is thin and has a small area and the support conductive units 12, 14, 17 and 19 are bonded to the first substrate 1 via the first insulating layers 3a and 3b made of inorganic insulating material. Accordingly, even if the ambient temperature increases, thermal stress in the bonding layer has little effect on the support structure of the support conductive units 12, 14, 17 and 19 and the fixed electrode units 11 and 13 and the movable electrode unit 15 are unlikely to be distorted due to this thermal stress.

Similarly, as the metal seal layer 45 surrounding the circumference of the movable region of the movable electrode unit 15 is a thin bonding layer formed between the frame layer 25 and the second insulating layer 30 and the frame layer 25 has a sufficient thickness, the first substrate 1 and the second substrate 2 are unlikely to be distorted due to thermal stress in the metal seal layer 45.

The overall thickness of the MEMS sensor may depend closely on the thickness of the first substrate 1 and second substrate 2, the thickness of the functional layer 10 and the thickness of the second insulating layer 30. Since the thickness of these substrates and layers can be controlled with high precision, a thickness variation is unlikely to occur. In addition, since the space portion 38 facing the movable region of the movable electrode unit 15 is formed in the second insulating layer 30, a movement margin in a thickness direction can be provided to the movable electrode unit 15 even when the overall thickness of the sensor is small, and, even when an external large acceleration is exerted in the thickness direction, the weight portion 20 and the movable counter electrodes 20a, 20b, 20c and 20d are unlikely to contact the second insulating layer 30, thereby preventing malfunction.

This MEMS sensor can be used as an acceleration sensor which detects acceleration in the Y1 or Y2 direction. For example, if acceleration in the Y1 direction is exerted on the MEMS sensor, the weight portion 20 of the movable electrode unit 15 is moved in the Y2 direction due to its reaction. In this case, the opposing distance δ1 (as shown in Fig. 2) between the movable counter electrode 20b and the fixed counter electrode 11c is increased to decrease capacitance between the movable counter electrode 20b and the fixed counter electrode 11c. Simultaneously, the opposing distance δ2 (as shown in Fig. 3) between the movable counter electrode 20b and the counter electrode 13c is decreased to increase capacitance between the movable counter electrode 20b and the counter electrode 13c.

By detecting such increase and decrease of capacitance with an electrical circuit and obtaining a difference between an output change due to the increase of the opposing distance δ1 and an output change due to the decrease of the opposing distance δ2, it is possible to detect a change and/or size of acceleration exerted in the Y1 direction.

In addition, in the present invention, as the weight portion 20 of the movable electrode unit 15 is moved in the thickness direction in response to acceleration exerted in a direction perpendicular to an X-Y plane and accordingly the counter electrodes 11b, 11c, 13b and 13c of the fixed electrode units 11 and 13 are deviated from the facing movable counter electrodes 20a, 20b and 20c of the movable electrode unit 15 in the thickness direction, thereby changing an opposing area, a change in capacitance between the movable counter electrode and the fixed counter electrode may be detected.

In a different embodiment shown in Fig. 6, a plurality of concave portions 51 and 52 are formed on the surface 30a of the second insulating layer 30 with an interval in the X1-X2 direction. In addition, concave regions 32c and 32d emulating these concave portions 51 and 52 are formed in the connection electrode 32. In addition, a flat plate-like connection region 32e connecting between the concave regions 32c and 32d is arranged on the surface 30a of the second insulating layer 30 located between the concave portions 51 and 52.

In addition, the connection metal layer 42 formed on the surface of the support conductive unit 17 faces the connection region 32e of the connection electrode unit 32, avoiding the concave regions 32c and 32d thereof, and the connection metal layer 42 and the connection region 32e, both of which have a flat plate shape, are eutectic-bonded or diffusion-bonded to each other.

In the embodiment shown in Fig. 6, the concave regions 32c and 32d are present in both sides of the connection region 32e, respectively. Accordingly, when the connection electrode unit 32 is viewed as a whole, the connection region 32e is present substantially in the central position. Accordingly, the connection region 32 can be easily defined and the connection metal layer 42 of the support conductive unit 17 can be appropriately arranged to face the connection region 32e of the connection conductive unit 32 by aligning the center of the connection electrode unit 32 with the center of the connection metal layer 42 for positional alignment. Accordingly, a variation of the bonding area can be more effectively suppressed, which may result in a more stable bonding strength. In addition, since the connection electrode unit 32 is connected to the lead layer 35 in the two concave regions 32c and 32d, it is possible to make better electrical connection between the connection electrode unit 32 and the lead layer 35.

In the embodiments of Figs. 5 and 6, if the length of the connection regions 32b and 32e in the X1-X2 direction and Y1-Y2 direction is set to be larger than that of the connection metal layer 42, the entire connection metal layer 42 can be advantageously inserted in the flat plate-like connection regions 32b and 32e, reliably avoiding the concave regions 32a, 32c and 32d.

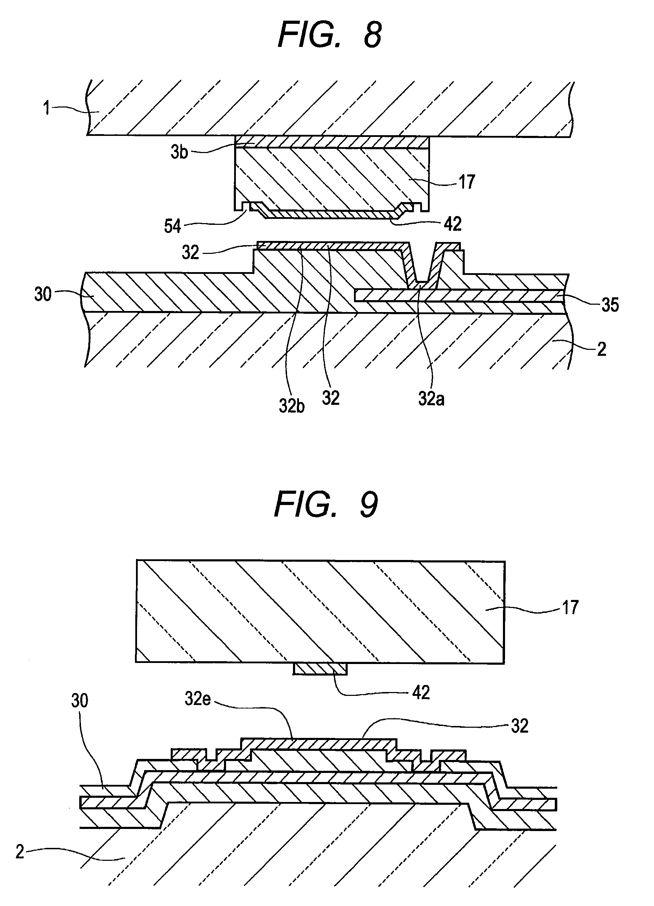

Figs. 7 and 8 show MEMS sensors according to preferred embodiments of the present invention, and show a state before bonding.

In the embodiment shown in Fig. 7, which is not part of the claimed invention, a groove 53 to surround a bonding portion between the connection metal layer 42 and the connection electrode unit 32 is formed in the surface of the support conductive unit 17 of the movable electrode unit 15. The groove 53 may be formed to surround the entire circumference of the bonding portion continuously or may be formed to surround the bonding portion with separation into a plurality of portions and with an interval.

In the embodiment shown in Fig. 8, which is not part of the claimed invention, a groove 54 to surround a bonding portion between the connection metal layer 42 and the connection electrode unit 32 is formed in the surface of the support conductive unit 17 of the movable electrode unit 15. The groove 54 is continuously formed around the bonding portion, with some of the connection metal layer 42 formed up to the inside of the groove 54.

In the embodiments shown in Figs. 7 and 8, when the connection electrode unit 32 is eutectic-bonded or diffusion-bonded to the connection metal layer 42, melted metal is blocked by the grooves 53 and 54, thereby reliably preventing the melted metal from flowing into the movable region of the weight portion 20 of the movable electrode unit 15 and the electrode opposing portions shown in Figs. 2 and 3.

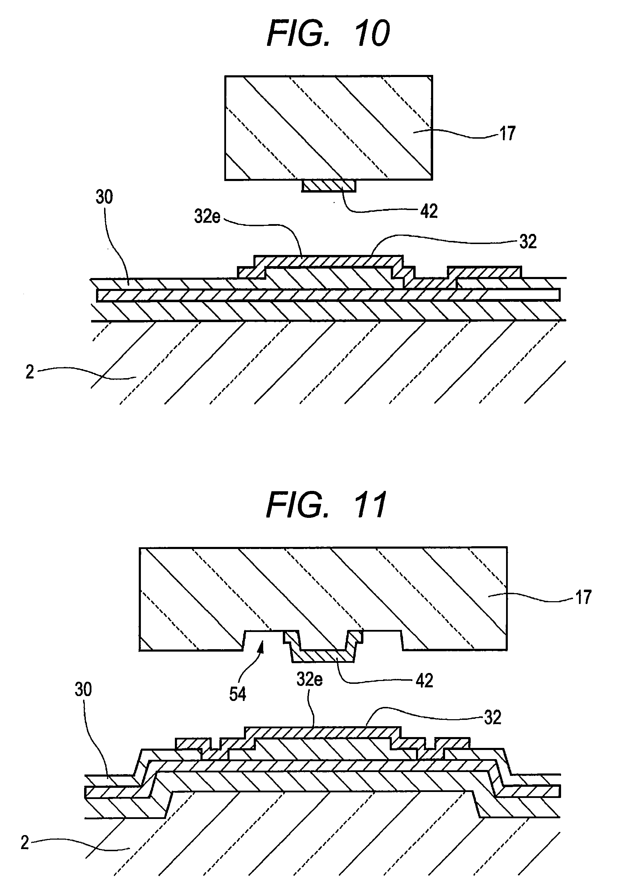

Figs. 9 to 12 illustrate steps, which are formed in the surface of the second substrate 2 or the second insulating layer 30 such that the connection region 32e is in highest level (i.e., projects).

In addition, although in the above embodiments the connection electrode units 31 and 32 and the seal electrode unit 33 are made of aluminum and the connection metal layers 41 and 42 and the seal metal layer 43 are made of germanium, examples of combinations of metals which can be eutectic-bonded or diffusion-bonded may include aluminum-zinc, gold-silicon, gold-indium, gold-germanium, gold-tin and so on. These combinations of metals allow the metals to be bonded at a relatively low temperature which is equal to or less than 450□C which is a temperature lower than the melting point of each of the metals.

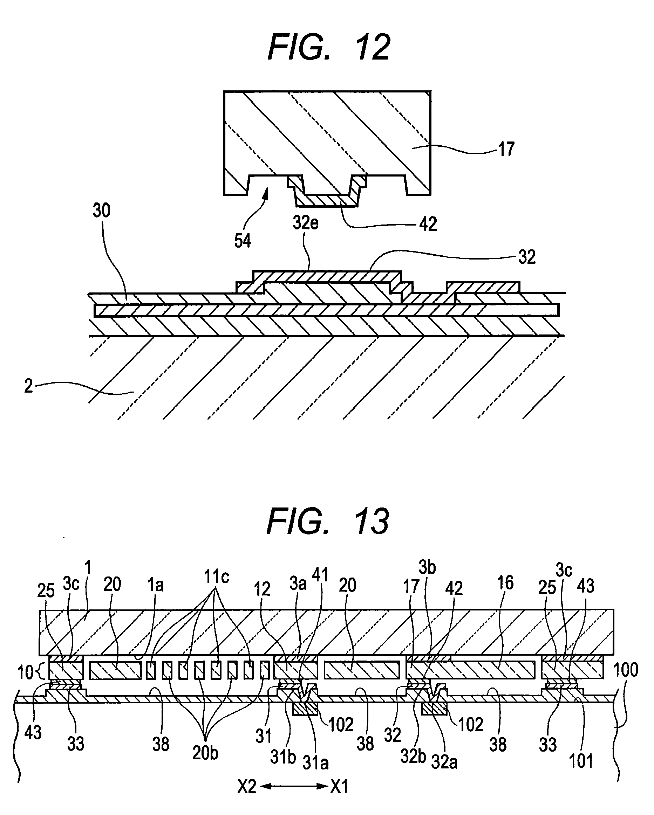

In addition, as shown in Fig. 13, the second substrate 2 may be an IC package 100 instead of the silicon substrate. A detecting circuit which detects a change in capacitance between a fixed counter electrode and a movable counter electrode may be incorporated into the IC package 100.

The second insulating layer 30 is formed on the top face 101 of the IC package 100, and the connection electrode units 31 and 32 and the seal electrode unit 33 are formed on the surface of the second insulating layer 30. As in Fig. 4, the connection electrode units 31 and 32 are formed over a range from the inside of the concave portion formed in the second insulating layer 30 to the surface of the second flat insulating layer 30. Accordingly, the connection electrode units 31 and 32 are configured to have concave regions 31a and 32a and flat plate-like connection regions 31b and 32b extending from one end portion of the concave regions 31 a and 32a.

When the IC package is used, the lead layers 34 and 35 are not necessarily formed in the second insulating layer 30 but the connection electrode units 31 and 32 can be directly or indirectly connected to electrode pads 102 of the IC package.

### BRIEF DESCRIPTION OF THE DRAWINGS

Fig. 1 is a plan view of an MEMS sensor according to an embodiment of the present invention, showing a movable electrode unit, a fixed electrode unit and a frame layer. In figure 1, figures of the first and the second substrates are omitted;
Fig. 2 is an enlarged plan view of a portion indicated by an arrow II in Fig. 1;
Fig. 3 is an enlarged plan view of a portion indicated by an arrow III in Fig. 1;
Fig. 4 is a sectional view showing a stacked structure of an MEMS sensor, which is not part of the claimed invention, corresponding to a sectional view taken along line IV-IV in Fig. 1;
Fig. 5 is an enlarged sectional view of a portion indicated by an arrow V in Fig. 4.
Fig. 6 is an enlarged sectional view of an MEMS sensor according to an embodiment of the invention;
Fig. 7 is an enlarged sectional view of an MEMS sensor according to a preferred embodiment of the present invention;
Fig. 8 is an enlarged sectional view of an MEMS sensor, which is not part of the claimed invention;
Fig. 9 is an enlarged sectional view of an MEMS sensor according to another embodiment of the present invention;
Fig. 10 is an enlarged sectional view of an MEMS sensor, which is not an embodiment of the present invention;
Fig. 11 is an enlarged sectional view of an MEMS sensor according to yet still another embodiment of the present invention;
Fig. 12 is an enlarged sectional view of an MEMS sensor, which is not an embodiment of the present invention;
Fig. 13 is a sectional view showing an embodiment, which is not part of the claimed invention, where an IC package is used instead of a second substrate.
Fig. 14 is a sectional view of an MEMS sensor shown as a comparative example for comparison with an embodiment of the present invention; and
Fig. 15 is an enlarged sectional view of Fig. 14.

### DESCRIPTION OF REFERENCE SIGNS

1: FIRST SUBSTRATE
2: SECOND SUBSTRATE
3a, 3b, 3c and 3d: FIRST INSULATING LAYER
10: FUNCTIONAL LAYER
11: FIRST FIXED ELECTRODE UNIT
12: SUPPORT CONDUCTIVE UNIT
11b and 11c: COUNTER ELECTRODE
13: SECOND FIXED ELECTRODE UNIT
14: SUPPORT CONDUCTIVE UNIT
13b and 13c: COUNTER ELECTRODE
15: MOVABLE ELECTRODE UNIT
16: FIRST SUPPORT FOREARM PORTION
17: SUPPORT CONDUCTIVE UNIT
18: SECOND SUPPORT FOREARM PORTION
19: SUPPORT CONDUCTIVE UNIT
20: WEIGHT PORTION
20a, 20b, 20c and 20d: MOVABLE COUNTER ELECTRODE
21, 22, 23 and 24: ELASTIC SUPPORT PORTION
25: FRAME LAYER
30: SECOND INSULATING LAYER
31 and 32: CONNECTION ELECTRODE UNIT
31a, 32a, 32c and 32d: CONCAVE REGION
31b, 32b and 32e: CONNECTION REGION
33: SEAL ELECTRODE UNIT
34 and 35: lead layer
37: CONCAVE PORTION
38: SPACE PORTION
41 and 42: CONNECTION METAL LAYER
43: SEAL METAL LAYER
45: METAL SEAL LAYER
51 and 52: CONCAVE PORTION
100: IC PACKAGE

## Claims

1. An MEMS sensor comprising:
a first substrate(1);
a second substrate (2); and
a functional layer (10) including a movable electrode unit (15) and a fixed electrode unit (11, 13) which are interposed between the first substrate (1) and the second substrate (2),
wherein, each of support conductive units (12, 14, 17, 19) of the movable electrode unit (15) and the fixed electrode unit (11, 13) is fixedly supported via a first insulating layer (3a, 3b, 3c) formed on a surface (1 a) of the first substrate (1),
a second insulating layer (30), a lead layer (34, 35) and a connection electrode unit (31, 32) are formed on a surface of the second substrate (2), the lead layer (34, 35) being embedded in the second insulating layer (30), and the connection electrode unit (31, 32) making electrical connection with the lead layer (34, 35) and being individually connected to the support conductive units (12, 14, 17, 19), and
the support conductive units (12, 14, 17, 19) are bonded to the connection region (31 b, 32b, 32e) of the connection electrode unit (31, 32);
**characterized in that**
a connection metal layer (41, 42) is formed on a surface of each of the support conductive units (12, 14, 17, 19) and is eutectic-bonded or diffusion-bonded to the connection region (31 b, 32b; 32e) of the connection electrode unit (31, 32),
a frame layer (25) is formed at the same thickness as the movable electrode unit (15) and the fixed electrode unit (11, 13) and is made of the same material as the movable electrode unit (15) and the fixed electrode unit (11, 13), the frame layer (25) surrounding a movable region of the movable electrode unit (15),
the first substrate (1) is bonded to the frame layer (25) in the outer circumference of the movable region via an insulating layer (3c) equal to the first insulating layer (3a, 3b, 3c),
a seal electrode unit (33) made of the same metal material as the connection electrode unit (31, 32) is formed on the surface of the second insulating layer (30), a seal metal layer (43, 45) made of the same metal material as the connection metal layer (41, 42) is formed on a surface of the frame layer (25), and the seal electrode unit (33) and the seal metal layer (43, 45) are eutectic-bonded or diffusion-bonded to each other to form a seal layer to surround the outer circumference of the movable region,
a first concave portion (51) and a second concave portion (52), which penetrate up to a surface of the lead layer (35) and which are open toward the first substrate (1), are formed on the surface (30a) of the second insulating layer (30),
the connection electrode unit (32) includes a first concave region (32c) and a second concave region (32d), which emulate said concave portions (51, 52) and which are connected to the lead layer (35) at an interval, the connection region (32e) connecting between the concave regions (32c, 32d) and being arranged on the surface (30a) of the second insulating layer (30) located between the first concave portion (51) and the second concave portion (52).

2. The MEMS sensor according to Claim 1,
wherein the length of the connection region (32b, 32e) is larger than that of the connection metal layer (42).

3. The MEMS sensor according to any one of Claims 1 or 2,
wherein the second insulating layer (30) is formed on a surface of an IC package (100) as the second substrate (2), and a concave region (31a, 32a) of the connection electrode unit (31, 32) is directly or indirectly connected to an electrode pad (102) of the IC package (100).

4. The MEMS sensor according to any of claims 1 to 3,
wherein the lead layer (34, 35) embedded in the second insulating layer (30) is drawn out to the outer side of the seal layer.

5. The MEMS sensor according to any of claims 1 to 4,
wherein a groove (53) surrounding a bonding portion between the connection metal layer (42) and the connection electrode unit (32) is formed in the surface of the support conductive unit (17) of the movable electrode unit (15).

6. The MEMS sensor according to Claim 5,
wherein the groove (53) is formed to surround the entire circumference of the bonding portion continuously or to surround the bonding portion with separation into a plurality of portions and with an interval.

7. The MEMS sensor according to claim 5,
wherein the groove (54) is continuously formed around the bonding portion, with some of the connection metal layer (42) formed up to the inside of the groove (54).

8. The MEMS sensor according to any of claims 1 to 4,
wherein the respective lead layers (34, 35) pass through the inside of the second insulating layer (30), and extend, without contacting the seal electrode unit 33, to the outside of a region surrounded by the seal electrode unit (33), and
wherein connection pads (36) are electrical connected with the respective lead layers (34, 35).

## Patentansprüche

1. Ein MEMS-Sensor mit:
einem ersten Substrat (1);
einem zweiten Substrat (2); und
einer Funktionsschicht (10), die eine bewegliche Elektrodeneinheit (15) und eine feststehende Elektrodeneinheit (11, 13) aufweist, die zwischen dem ersten Substrat (1) und dem zweiten Substrat (2) eingefügt sind,
wobei leitende Abstützeinheiten (12,14, 17, 19) sowohl der beweglichen Elektrodeneinheit (15) als auch der feststehenden Elektrodeneinheit (11, 13) befestigend auf einer ersten isolierenden Schicht (3a, 3b, 3c) gelagert sind, die auf einer Oberfläche (1a) des ersten Substrats ausgebildet ist,
wobei eine zweite isolierende Schicht (30), eine Leiterschicht (34, 35) und eine Verbindungselektrodeneinheit (31, 32) auf einer Oberfläche des zweiten Substrats (2) ausgebildet sind, wobei die Leiterschicht (34, 35) in die zweite isolierende Schicht (30) eingebettet ist und wobei die Verbindungselektrodeneinheit (31, 32) in elektrischer Verbindung mit der Leiterschicht (34, 35) steht und individuell mit den leitenden Lagereinheiten (12, 14, 17, 19) verbunden ist, und
wobei die leitenden Abstützeinheiten (12, 14, 17, 19) mit dem Verbindungsbereich (31b, 32b; 32e) der Verbindungelektrodeneinheit (31, 32) verbunden sind;
**dadurch gekennzeichnet, dass**
eine metallische Verbindungsschicht (41, 42) auf einer Oberfläche von jeder der leitenden Abstützeinheiten (12, 14, 17, 19) ausgebildet und eutektisch oder durch Diffusion mit dem Verbindungsbereich (31b, 32b; 32e) der Verbindungselektrodeneinheit (21, 32) verbunden ist,
eine Rahmenschicht (25) mit der gleichen Dicke wie die bewegliche Elektrodeneinheit (15) und die feststehende Elektrodeneinheit (11,13) ausgebildet und aus dem gleichen Material wie die bewegliche Elektrodeneinheit (15) und die feststehende Elektrodeneinheit (11, 13) hergestellt ist, wobei die Rahmenschicht (25) einen beweglichen Bereich der beweglichen Elektrodeneinheit (15) umgibt,
das erste Substrat (11) durch eine isolierende Schicht (3c), die gleich der ersten isolierenden Schicht (3a, 3b, 3c) ist, am äußeren Umfang des beweglichen Bereichs mit der Rahmenschicht (25) verbunden ist,
eine Dichtungselektrodeneinheit (33), die aus dem gleichen Metallmaterial wie die Verbindungselektrodeneinheit (31, 32) hergestellt ist, auf der Oberfläche der zweiten isolierenden Schicht (30) ausgebildet ist, eine metallische Dichtungsschicht (43, 45), die aus dem gleichen Metallmaterial wie die metallische Verbindungsschicht (41, 42) hergestellt ist, auf einer Oberfläche der Rahmenschicht (25) ausgebildet ist, und die Dichtungselektrodeneinheit (33) und die metallische Dichtungsschicht (43, 45) eutektisch oder durch Diffusion miteinander verbunden sind, um eine Dichtungsschicht auszubilden, die den äußeren Umfang des beweglichen Bereichs umgibt,
ein erster konkaver Bereich (51) und ein zweiter konkaver Bereich (52), die sich bis zur Oberfläche der Leiterschicht (35) hindurch erstrecken und die zum ersten Substrat (1) hin offen sind, auf der Oberfläche (30a) der zweiten isolierenden Schicht (30) ausgebildet sind,
die Verbindungselektrodeneinheit (32) einen ersten konkaven Bereich (32c) und einen zweiten konkaven Bereich (32d) enthält, welche die konkaven Bereiche (51, 52) nachbilden und die in einem Abstand mit der Leiterschicht (35) verbunden sind, wobei der Verbindungsbereich (32e) die beiden konkaven Regionen (32c, 32d) miteinander verbindet und auf der Oberfläche (30a) der zweiten isolierenden Schicht (30) zwischen dem ersten konkaven Bereich (51) und dem zweiten konkaven Bereich (52) angeordnet ist.

2. Der MEMS-Sensor nach Anspruch 1,
wobei die Länge des Verbindungsbereichs (32b, 32e) größer als die der metallische Verbindungsschicht (42) ist.

3. Der MEMS-Sensor nach einem der Ansprüche 1 oder 2,
wobei die zweite isolierende Schicht (30) auf einer Oberfläche einer IC-Einheit (100) als dem zweiten Substrat (2) ausgebildet ist, und wobei eine konkave Region (31a, 32a) der Verbindungselektrodeneinheit (31, 32) direkt oder indirekt mit einem Elektrodenpad (102) der IC-Einheit (100) verbunden ist.

4. Der MEMS-Sensor nach einem der Ansprüche 1 bis 3,
wobei die Leiterschicht (34, 35), die in die zweite isolierende Schicht (30) eingebettet ist, zur Außenseite der Dichtungsschicht herausgezogen ist.

5. Der MEMS-Sensor nach einem der Ansprüche 1 bis 4,
wobei in der Fläche der leitenden Abstützeinheit (17) der beweglichen Elektrodeneinheit (15) eine Nut (53) ausgebildet ist, die einen Verbindungsbereich zwischen der metallische Verbindungsschicht (52) und der Verbindungselektrodeneinheit (32) umgibt.

6. Der MEMS-Sensor nach Anspruch 5,
wobei die Nut (53) so ausgebildet ist, dass sie den gesamten Umfang des Verbindungsbereichs durchgängig umgibt oder dass sie den Verbindungsbereich mit einer Trennung in mehrere voneinander beabstandete Bereiche umgibt.

7. Der MEMS-Sensor nach Anspruch 5,
wobei die Nut (54) durchgängig um den Verbindungsbereich ausgebildet ist, wobei ein Teil der metallische Verbindungsschicht (42) bis zur Innenseite der Nut ausgebildet ist.

8. Der MEMS-Sensor nach einem der Ansprüche 1 bis 4,
wobei die jeweiligen Leiterschichten (34, 35) durch das Innere der zweiten isolierenden Schicht (30) verlaufen und sich bis außerhalb eines Bereichs erstrecken, der von der Dichtungselektrodeneinheit (33) umgeben ist, ohne die Dichtungselektrodeneinheit (33) zu berühren, und
wobei Verbindungspads (36) elektrisch mit dem jeweiligen Leiterschichten (34, 35) verbunden sind.

## Revendications

1. Capteur MEMS, comportant :
un premier substrat (1) ;
un second substrat (2) ; et
une couche fonctionnelle (10) comprenant un dispositif d'électrode mobile (15) et un dispositif d'électrode fixe (11, 13) intercalés entre le premier substrat (1) et le second substrat (2),
dans lequel chacun des éléments de support conducteurs (12, 14, 17, 19) du dispositif d'électrode mobile (15) et du dispositif d'électrode fixe (11, 13) est supporté à demeure par l'intermédiaire d'une première couche isolante (3a, 3b, 3c) formée sur une surface (1a) du premier substrat (1),
une seconde couche isolante (30), une couche conductrice (34, 35) et un dispositif d'électrode de connexion (31, 32) sont formés sur une surface du second substrat (2), la couche conductrice (34, 35) étant encastrée dans la seconde couche isolante (30) et le dispositif d'électrode de connexion (31, 32) établissant une connexion électrique avec la couche conductrice (34, 35) et étant connecté individuellement aux éléments de support conducteurs (12, 14, 17, 19), et
les éléments de support conducteurs (12, 14, 17, 19) sont fixés à la région de connexion (31b, 32b, 32e) du dispositif d'électrode de connexion (31, 32) ;
**caractérisé en ce que**
une couche métallique de connexion (41, 42) est formée sur une surface de chacun des éléments de support conducteurs (12, 14, 17, 19) et est fixée par soudage eutectique ou par soudage par diffusion à la région de connexion (31b, 32b ; 32e) du dispositif d'électrode de connexion (31, 32),
une couche d'encadrement (25) est formée sur la même épaisseur que le dispositif d'électrode mobile (15) et le dispositif d'électrode fixe (11, 13) et est faite de la même matière que le dispositif d'électrode mobile (15) et le dispositif d'électrode fixe (11, 13), la couche d'encadrement (25) entourant une région mobile du dispositif d'électrode mobile (15),
le premier substrat (1) est fixé à la couche d'encadrement (25) sur le pourtour extérieur de la région mobile par l'intermédiaire d'une couche isolante (3c) égale à la première couche isolante (3a, 3b, 3c),
un dispositif d'électrode de fermeture (33) fait de la même matière métallique que le dispositif d'électrode de connexion (31, 32) est formé à la surface de la seconde couche isolante (30), une couche métallique de fermeture (43, 45) faite de la même matière que la couche métallique de connexion (41, 42) est formée sur une surface de la couche d'encadrement (25), et le dispositif d'électrode de fermeture (33) et la couche métallique de fermeture (43, 45) sont fixés l'un à l'autre par soudage eutectique ou fixé l'un à l'autre par soudage par diffusion afin de former une couche de fermeture pour entourer le pourtour extérieur de la région mobile,
une première partie concave (51) et une seconde partie concave (52), qui pénètrent jusqu'à une surface de la couche conductrice (35) et qui débouchent vers le premier substrat (1), sont formées sur la surface (30a) de la seconde couche isolante (30);
le dispositif d'électrode de connexion (32) comprend une première région concave (32c) et une seconde région concave (32d), qui ressemblent auxdites parties concaves (51, 52) et qui sont connectées à la couche conductrice (35) au niveau d'un intervalle, la région de connexion (32e) permettant une connexion entre les régions concaves (32c, 32d) et étant aménagée sur la surface (30a) de la seconde couche isolante (30) située entre la première partie concave (51) et la seconde partie concave (52).

2. Capteur MEMS selon la revendication 1,
dans lequel la longueur de la région de connexion (32b, 32e) est plus grande que celle de la couche métallique de connexion (42).

3. Capteur MEMS selon l'une quelconque des revendications 1 et 2,
dans lequel la seconde couche isolante (30) est formée sur une surface d'un boîtier de CI (100) servant de second substrat (2), et une région concave (31a, 32a) du dispositif d'électrode de connexion (31, 32) est directement ou indirectement connectée à une pastille (102) d'électrode du boîtier de CI (100).

4. Capteur MEMS selon l'une quelconque des revendications 1 à 3,
dans lequel la couche conductrice (34, 35) encastrée dans la seconde couche isolante (30) est amenée à atteindre la face externe de la couche de fermeture.

5. Capteur MEMS selon l'une quelconque des revendications 1 à 4,
dans lequel une gorge (53) entourant une partie de fixation entre la couche métallique de connexion (42) et le dispositif d'électrode de connexion (32) est formée dans la surface de l'élément de support conducteur (17) du dispositif d'électrode mobile (15).

6. Capteur MEMS selon la revendication 5,
dans lequel la gorge (53) est formée de manière à entourer d'une manière continue la totalité de la partie de fixation ou à entourer la partie de fixation avec une séparation en une pluralité de parties et avec un intervalle.

7. Capteur MEMS selon revendication 5,
dans lequel la gorge (54) est formée d'une manière continue autour de la partie de fixation, une partie de la couche métallique de connexion (42) étant formée jusqu'à l'intérieur de la gorge (54).

8. Capteur MEMS selon l'une quelconque des revendications 1 à 4,
dans lequel les couches conductrices respectives (34, 35) traversent l'intérieur de la seconde couche isolante (30) et s'étendent, sans toucher le dispositif d'électrode de fermeture (33), jusqu'à l'extérieur d'une région entourée par le dispositif d'électrode de fermeture (33), et
dans lequel des plages de connexion (36) sont connectées électriquement aux couches conductrices respectives (34, 35).
